# DEMANDE DE BREVET EUROPEEN

(11) **EP 2 208 988 A1**
(43) Date de publication de la demande: **21.07.2010**
(21) Numéro de dépôt: 09306231.3
(22) Date de dépôt: 15.12.2009
(51) Int. Cl.: G01N 21/89, F21V 5/04, G01N 21/88, H01L 33/00, F21V 17/10, F21V 17/04, F21Y 101/02, F21W 131/403

(54) **Dispositif d'éclairage à diodes électroluminescentes**

(30) Priorité: 16.12.2008 FR 0858627
(71) Demandeur: Effilux, 91400 Orsay (FR)
(72) Inventeur: Sabater, Jacques, 91190, GIF SUR YVETTE (FR)
(74) Mandataire: Michelet, Alain

(57) **Abrégé**

L'invention concerne un dispositif d'éclairage à diode comprenant plusieurs diodes électroluminescentes ou DELs, alignées suivant un axe, associées à une lentille cylindrique, ledit dispositif étant apte à produire une bande lumineuse d'éclairement sensiblement uniforme.

Selon l'invention, le système optique comprend, associé à chaque DEL, une lentille boule tronquée disposée de telle manière que la réfraction des rayons lumineux issus du centre de la zone émissive de ladite DEL soit de type aplanétique, et la lentille cylindrique étant une lentille à échelons de Fresnel.

## Description

La présente invention concerne de manière générale le domaine de l'éclairage, en particulier les éclairages devant répondre à des spécificités particulières, notamment aptes à produire un éclairement concentré uniforme sur une ligne, et a pour objet un dispositif d'éclairage à diode.

Dans certains domaines ou certaines applications, il est nécessaire de disposer d'un éclairage répondant à certaines spécifications techniques, voire réglementaires, par exemple en termes d'intensité ou d'uniformité de l'éclairage au niveau de la zone à éclairer.

Tel est notamment le cas, à titre d'exemple illustratif, dans le domaine des éclairages industriels permettant le contrôle de la qualité des produits plats sortant à grande vitesse d'une machine.

Les appareils du type précité, qui sont actuellement connus comportent généralement comme source(s) lumineuse(s) des ampoules halogènes ou à incandescence, ou des tubes fluorescents associées à une surface réfléchissante (réflecteur) et à une vitre de protection frontale, ils forment une ligne lumineuse de largeur typique de l'ordre de un à deux centimètres, cela sur une longueur allant de quelques dizaines de centimètres à plusieurs mètres.

Néanmoins, les appareils munis de lampes à incandescence existants sont relativement lourds, peu performants ou ne fournissent pas un éclairement avec un bon degré d'uniformité dans la zone cible à éclairer.

De plus, du fait de la nature même des sources lumineuses utilisées, ces appareils d'éclairage connus émettent beaucoup de chaleur et nécessitent des interventions fréquentes pour changer les ampoules (durée de vie limitée de 50 heures à 2 000 heures maximum).

Les appareils munis de tubes fluorescents donnent un éclairement uniforme mais notablement insuffisant dans le cas d'installation sur des machines rapides.

En effet, dans le cas de machines rapides telles que celles utilisées en papeteries ou les laminoirs, la grande vitesse de propagation du matériau à contrôler nécessite de la part du dispositif de prise de vue des temps d'acquisition très courts (entre un dix-millième et un cent-millième de seconde) qui imposent un éclairement très important impossible à obtenir avec des tubes fluorescents.

On connaît d'autre part des dispositifs d'éclairage à diodes électroluminescentes (généralement désignées par DEL ou LED). De telles diodes présentent une grande durée de vie, présentent une faible consommation et ne produisent pas une chaleur excessive.

Il existe en particulier, depuis peu, des DEL blanches, ou de couleur, de plus en plus performantes et puissantes, en termes de luminosité, qui peuvent se substituer aux lampes à incandescence ou halogènes.

Il est toutefois nécessaire d'associer à ces DEL des dispositifs ou systèmes permettant de récupérer le flux lumineux émis par elles et de l'amener au niveau de la surface à éclairer.

Ces dispositifs sont d'autant plus intéressants que les trois critères suivants sont au mieux vérifiés :
- le flux récupéré est le plus grand possible (meilleur rendement)
- l'éclairement est uniforme
- la zone éclairée est adaptée à l'objet que l'on veut éclairer.

Les dispositifs existants permettant une collecte maximale de lumière du flux de la DEL sont des composants optiques que l'on dispose contre la DEL et dénommés collimateurs.

Toutefois, ils sont très mauvais en termes d'uniformité et de concentration de la lumière. L'association d'un grand nombre de collimateurs sur une même ligne ne permet pas un éclairage efficace et uniforme sur une zone linéaire de grande longueur.

La présente invention s'intéresse plus particulièrement aux DEL ayant une indicatrice d'émission Lambertienne. Pour une émission parfaitement Lambertienne, l'indicatrice de rayonnement s'exprime par la variation I(θ) suivante :
I(θ) = I₀*cos(θ), où I₀ est l'intensité lumineuse en candelas ou en watts par stéradian dans la direction de l'axe d'émission du faisceau optique de la DEL et I(θ) est l'intensité lumineuse dans une direction faisant un angle θ avec l'axe.

Certaines DEL disponibles dans le commerce, comme par exemple celle connues sous la désignation Luxeon^{®} K2 ou Luxeon^{®} Rebel, ont, par construction, une indicatrice dont les variations sont très semblables à la formule ci-dessus.

Ce rayonnement couvre tout le demi-espace en avant de la LED soit un angle solide total Ω = 2π stéradians (6,28 stéradians).

Pour projeter ce rayonnement sur l'objet que l'on veut éclairer sur un écran éloigné typiquement de quelques centimètres à quelques dizaines de centimètres, il est nécessaire de prévoir un dispositif optique composé d'une ou plusieurs lentilles et/ou un miroir ou plusieurs miroirs ou dispositifs réfléchissants.

Les dispositifs à lentilles ont l'avantage de former une image très nette de la surface émissive de la DEL ce qui est très intéressant pour obtenir un éclairage uniforme, délimité et localisé sur la zone utile.

Pour obtenir une bande lumineuse intense avec une série de DELs, les DELs sont alignées sur support longitudinal parallèlement à une direction appelée axe du dispositif, elles sont séparées l'une de l'autre par une distance appelée pas, puis une simple lentille cylindrique dont les lignes directrices sont parallèles à l'axe permet alors la formation sur l'objet de la bande lumineuse par focalisation.

La ligne de DELs est disposée sur un radiateur principalement en aluminium qui permet un refroidissement correct des DELs.

Le rendement du système optique est le rapport entre le flux total émis par les DELs et le flux collecté qui participe à l'éclairement de la bande lumineuse.

Ce rendement est une donnée très importante du système car il permet soit d'augmenter l'éclairement pour un pas donné, soit d'augmenter le pas avec un éclairement identique.

L'augmentation du pas permet de disposer moins de DELs par mètre et permet de réduire les problèmes de refroidissement.

L'utilisation seule, d'une lentille cylindrique convergente a un rendement de l'ordre de 40%, il est primordial d'augmenter ce rendement.

A cet effet, la présente invention a pour objet un dispositif d'éclairage à diode, comprenant un ensemble de diodes électroluminescentes (DELs), alignées parallèlement à un axe, associées à un système optique apte à récupérer une part importante du flux lumineux émis par les DELs et à produire à distance une bande lumineuse sensiblement uniforme en termes d'éclairement.

Selon l'invention, le système optique comprend, d'une part, sur chaque DEL une lentille qui est une boule tronquée en matériau transparent disposée de telle manière que les rayons lumineux issus du centre de la zone émissive de la DEL qui sont réfractés par la face de sortie de la boule subissent une réfraction de type aplanétique, et d'autre part, une lentille cylindrique à échelons de type Fresnel dont les structures sont parallèles à l'axe d'alignement des DELs. Une telle combinaison permet d'obtenir un rendement supérieur à 80%.

Pour une lentille sphérique de rayon de courbure R et d'indice n, la réfraction est dite aplanétique quand l'objet lumineux est à une distance du sommet de ladite lentille égale à R+R/n.

Pour obtenir cela, la partie tronquée de la lentille boule est adaptée à la forme de la DEL.

Par exemple, dans le cas où la DEL possède une surface émissive recouverte d'une surface de protection plane transparente, il suffira de réaliser sur la lentille boule une troncature plane et placer la DEL de façon à ce que son image par réfraction dans le plan de troncature soit à la distance R+R/n.

Généralement les DELs disposent d'un élément transparent bombé, généralement en matériau plastique collé sur la zone émissive. Cet élément transparent peut être de forme hémisphérique, il est alors appelé dôme.

Dans ce cas, pour satisfaire à la condition de réfraction aplanétique, on pratique, dans la partie tronquée de la lentille boule, un orifice centré sur l'axe de la lentille boule, qui a une dimension légèrement supérieure à celle de l'élément transparent de la DEL.

Ledit orifice permet d'y insérer et préférentiellement d'y coller avec une colle transparente, l'élément transparent permettant un positionnement correct de la surface émissive de la DEL.

Après collage, le centre de la zone émissive doit être à une distance du sommet de la lentille très proche de R+R/n pour que la réfraction sur la face de sortie de la lentille boule soit aplanétique. Une tolérance de positionnement en tout sens de la zone émissive égale à la moitié de la dimension latérale de ladite zone émissive est généralement admise.

La modification de la distance entre la lentille de Fresnel et les lentilles boule permet une modification de la distance de meilleure focalisation de la bande lumineuse et par conséquent une modification de la largeur de la bande lumineuse. L'éclairement moyen étant inversement proportionnel à la largeur de la bande lumineuse, suivant le cas, en fonction de l'application désirée, on peut ainsi obtenir une bande lumineuse d'éclairement plus ou moins élevé. Dans certains cas il est donc avantageux de prévoir un dispositif permettant une modification de la distance entre la lentille de Fresnel et les lentilles boules.

Plus précisément, l'invention concerne un dispositif d'éclairage à diode comprenant plusieurs diodes électroluminescentes ou DELs, alignées suivant un axe, associées à une lentille cylindrique, ledit dispositif étant apte à produire une bande lumineuse d'éclairement sensiblement uniforme.

Selon l'invention, le système optique comprend, associé à chaque DEL, une lentille boule tronquée disposée de telle manière que la réfraction des rayons lumineux issus du centre de la zone émissive de ladite DEL soit de type aplanétique, et, en ce que la lentille cylindrique est une lentille à échelons de Fresnel.

Dans différents modes de réalisation possibles, la présente invention concerne également les caractéristiques suivantes qui pourront être considérées isolément ou selon toutes leurs combinaisons techniquement possibles et apportent chacune des avantages spécifiques :
- la lentille boule possède un orifice apte à recevoir l'élément transparent de la DEL,
- la lentille boule est collée sur l'élément transparent de la DEL à l'aide d'une colle transparente,
- la lentille cylindrique à échelons de Fresnel a une directrice parallèle à l'axe d'alignement des DELs,
- les échelons de la lentille cylindrique à échelons de Fresnel sont formés sur la face de la lentille orientée vers la DEL,
- les échelons de la lentille cylindrique à échelons de Fresnel sont formés sur la face de la lentille opposée à la DEL,
- les DELs sont fixées sur un radiateur cylindrique d'axe parallèle à l'axe d'alignement des DELs,
- les DELs émettent une radiation blanche,
- les DELs émettent une radiation colorée,
- les DELs émettent des radiations de couleurs différentes,
- la distance entre les lentilles boules et la lentille de Fresnel est variable.

L'invention sera mieux comprise, grâce à la description ci-après, qui se rapporte à un mode de réalisation préféré, donné à titre d'exemple non limitatif, et expliqué avec référence aux dessins schématiques annexés, dans lesquels :
La figure 1 est une représentation schématique d'un dispositif d'éclairage selon l'invention comprenant une ligne de 5 DELs avec les lentilles boules associées et une lentille de Fresnel cylindrique; Pour des lignes plus longues, le même schéma est reproduit autant de fois que nécessaire le long de l'axe d'alignement des DELs.
La figure 2 est une vue en coupe, du dispositif dans un plan perpendiculaire à l'axe d'alignement des DELs, il comprend la DEL, la zone émissive, le dôme de la zone émissive qui peut être collé à la lentille boule, la lentille boule, la lentille de Fresnel et la zone de concentration des rayons lumineux.

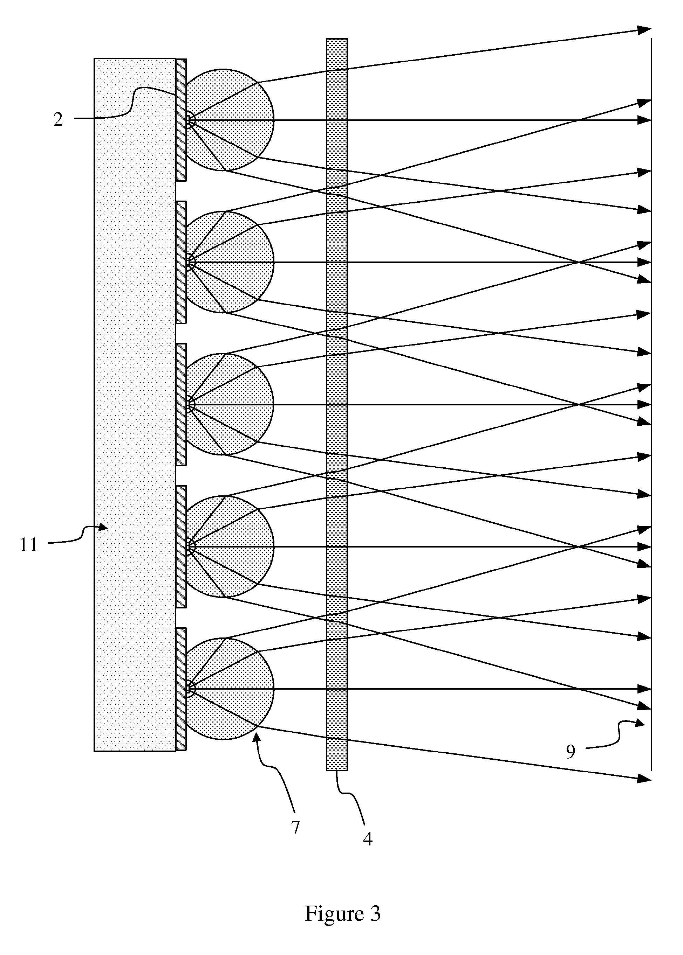

La figure 3 est une vue en coupe du dispositif dans un plan parallèle à l'axe.

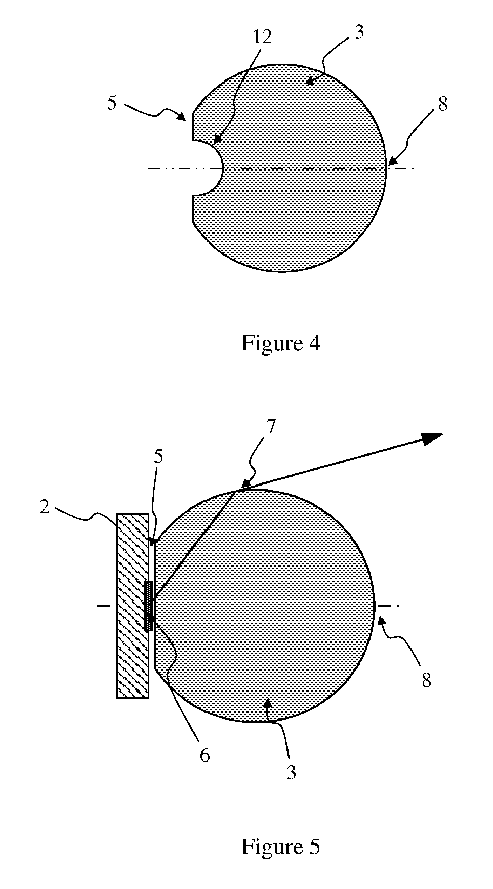

La figure 4 est une vue en coupe de la lentille boule tronquée.
La figure 5 est une vue en coupe d'une DEL dont la lentille de sortie est quasi plane et non collée à la lentille boule, cette dernière étant tronquée par un plan poli et qui est disposé très près de la zone émissive de la DEL sans être collée.
La figure 6 est une courbe graduée en lux, illustrant la distribution de l'intensité de l'éclairement fourni par une série de DELs dans la direction perpendiculaire à l'axe d'alignement des DELs, sur un écran situé à 15 cm de la ligne de DELs.

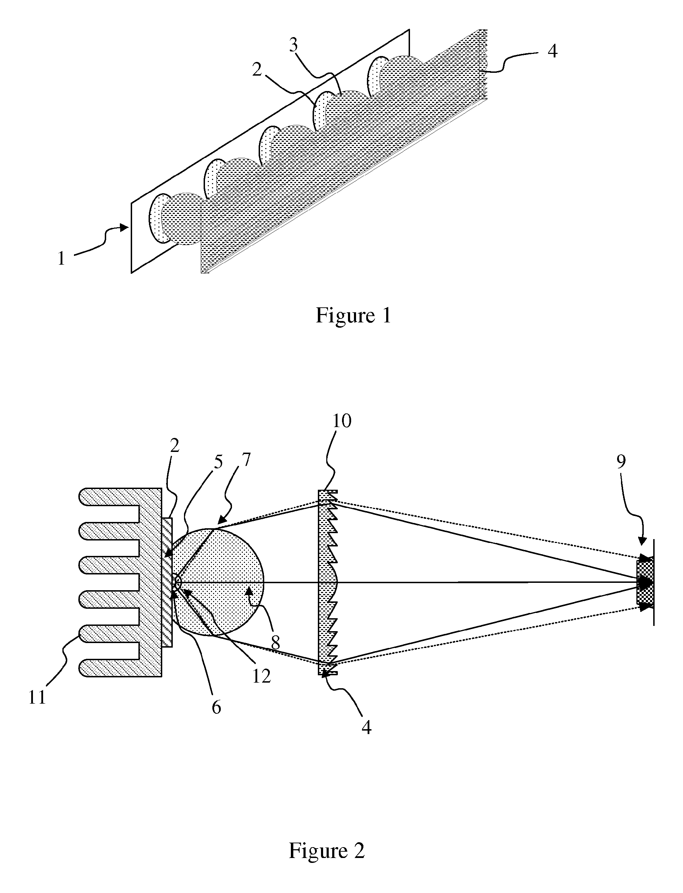

Comme le montre la figure 1 des dessins annexés, le dispositif d'éclairage 1 comprend plusieurs DELs 2 associées à un système optique complexe qui comprend des lentilles boule 3 collées aux DELs et une lentille de Fresnel 4.

Selon l'invention, la lentille boule 3, de rayon de courbure R, fabriquée dans un matériau d'indice n, est tronquée en sa partie inférieure suivant un plat 5 disposé de telle manière qu'il positionne la surface émissive de la DEL 6 à une distance du sommet 8 de la lentille boule approximativement égale à R+R/n de façon à ce que les réfractions des rayons lumineux 7 subissent une réfraction de type aplanétique.

La lentille de Fresnel 4 est disposée de façon à focaliser le rayonnement lumineux sur la zone à éclairer 9. La lentille de Fresnel est réalisé dans un matériau transparent, généralement en plastique. Ses structures ou échelons 10 peuvent être disposés suivant les cas, soit du côté de la DEL soit du côté de la zone à éclairer.

Afin d'évacuer la chaleur dégagée, les DELs sont préférentiellement fixées sur un radiateur 11 parallèle à l'axe de la ligne de DELs.

Ainsi, le principe de base de l'invention consiste à interposer entre la DEL 2 et la lentille de Fresnel 4 un composant optique 3 d'indice n en verre ou en matériau plastique transparent tel que polycarbonate ou acrylique qui permette une amélioration du rendement.

Ce composant optique 3 est préférentiellement une lentille boule, de rayon de courbure R, tronquée à sa base par un plan 5 et disposant d'un orifice 12 au centre de la zone plane, l'ensemble étant réalisé de façon à ce que la DEL et son élément transparent de protection ou dôme puisse s'insérer dans l'orifice 12 et de façon à ce que la surface émissive de la DEL soit à la distance R+R/n du sommet 8 de la lentille boule.

Par exemple non limitatif, les DELS sont des Luxeon^{®} Rebel émettant un flux lumineux de 100 lumens, elles sont disposées sur un axe avec un pas de 30 mm.

Les lentilles boules ont un rayon de courbure de 5 mm, elles sont réalisées dans du plastique transparent communément nommé PMMA, la distance de la surface émissive de la DEL au sommet de la lentille boule est égale à 8,4 mm, une incertitude de 0,5 mm est permise. Chaque DEL a un élément transparent qui est collé dans un orifice pratiqué dans la lentille boule.

Le collage de la DEL sur la lentille boule cumule deux avantages. Il permet une fixation solide de la lentille boule sur la DEL et évite ainsi une monture mécanique compliquée pour maintenir la lentille boule. En outre il évite les réflexions parasites sur la face de sortie du dôme de la DEL et de la face d'entrée des rayons lumineux dans la lentille boule, améliorant ainsi le rendement lumineux.

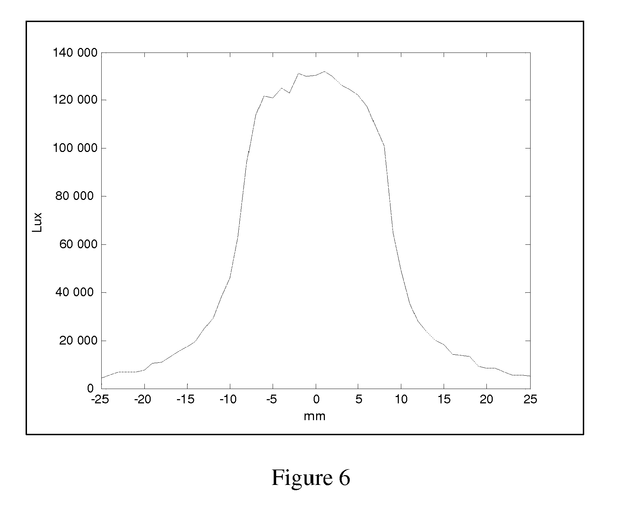

La lentille cylindrique est une lentille de Fresnel de distance focale 20 mm située à 9 mm du sommet des lentilles boules. La figure 6 montre la distribution d'éclairement obtenue, dans la direction perpendiculaire à l'axe d'alignement des DELs, par le dispositif précité, sur un écran situé à 15 cm de la ligne de DELs.

## Revendications

1. Dispositif d'éclairage à diode comprenant plusieurs diodes électroluminescentes ou DELs, alignées suivant un axe, associées à une lentille cylindrique, ledit dispositif étant apte à produire une bande lumineuse d'éclairement sensiblement uniforme **caractérisé en ce que** le système optique comprend, associé à chaque DEL, une lentille boule tronquée disposée de telle manière que la réfraction des rayons lumineux issus du centre de la zone émissive de ladite DEL soit de type aplanétique, et, **en ce que** la lentille cylindrique est une lentille à échelons de Fresnel.

2. Dispositif selon la revendication 1 **caractérisé en ce que** la lentille boule possède un orifice apte à recevoir l'élément transparent de la DEL.

3. Dispositif selon les revendications 1 et 2 **caractérisé en ce que** la lentille boule est collée sur l'élément transparent de la DEL à l'aide d'une colle transparente.

4. Dispositif selon l'une quelconque des revendications 1 à 3 **caractérisé en ce que** la lentille cylindrique à échelons de Fresnel a une directrice parallèle à l'axe d'alignement des DELs.

5. Dispositif selon l'une quelconque des revendications 1 à 4 **caractérisé en ce que** les échelons de la lentille cylindrique à échelons de Fresnel sont formés sur la face de la lentille orientée vers la DEL.

6. Dispositif selon l'une quelconque des revendications 1 à 4 **caractérisé en ce que** les échelons de la lentille cylindrique à échelons de Fresnel sont formés sur la face de la lentille opposée à la DEL.

7. Dispositif selon l'une quelconque des revendications 1 à 6 **caractérisé en ce que** les DELs sont fixées sur un radiateur cylindrique d'axe parallèle à l'axe d'alignement des DELs.

8. Dispositif selon l'une quelconque des revendications 1 à 7 **caractérisé en ce que** les DELs émettent une radiation blanche.

9. Dispositif selon l'une quelconque des revendications 1 à 7 **caractérisé en ce que** les DELs émettent une radiation colorée.

10. Dispositif selon l'une quelconque des revendications 1 à 7 **caractérisé en ce que** les DELs émettent des radiations de couleurs différentes.

11. Dispositif selon l'une quelconque des revendications 1 à 10 **caractérisé en ce que** la distance entre les lentilles boules et la lentille de Fresnel est variable.
